# EUROPEAN PATENT APPLICATION

(11) **EP 1 605 479 A2**
(43) Date of publication of application: **14.12.2005**
(21) Application number: 05251936.0
(22) Date of filing: 29.03.2005
(51) Int. Cl.: H01G 9/20

(54) **Flexible dye-sentitized solar cell using conducting metal substrate**

(30) Priority: 09.06.2004 KR 2004042213
(71) Applicant: ELECTRONICS AND TELECOMMUNICATIONS RESEARCH INSTITUTE, Daejeon-Shi (KR)
(72) Inventor: Kang, Man Gu, Daejeon-city (KR); Park, Nam-Gyu, Daejeon-city (KR); Kim, Kwang Man, Daejeon-city (KR); Hong, Young Sik, Daejeon-city (KR); Park, Yong Joon, Daejeon-city (KR); Lee, Young Gi, Daejeon-city (KR); Kang, Man Gu, Daejeon-city (KR); Chang, Soon Ho, Daejeon-city (KR); Ryu, Kwang Sun, Daejeon-city (KR)
(74) Representative: Powell, Timothy John

(57) **Abstract**

A flexible dye-sensitized solar cell is provided. The solar cell is formed by assembling a semiconductor electrode prepared by forming a nanoparticle oxide layer on a first flexible conducting substrate composed of a metal, such as a stainless steel, and allowing a dye to be adsorbed thereon and a counter electrode including a Pt layer formed on a second flexible conducting substrate composed of a transparent polymer. When a semiconductor electrode including an insulating thin film and a conducting thin film formed on the first conducting substrate is used, an energy conversion efficiency of the solar cell can be significantly improved when compared to a conventional flexible solar cell.

## Description

### BACKGROUND OF THE INVENTION

This application claims the benefit of Korean Patent Application No. 10-2004-0042213, filed on June 9, 2004, in the Korean Intellectual Property Office, the disclosure of which is incorporated herein in its entirety by reference.

### 1. Field of the Invention

The present invention relates to a solar cell, and more particularly, to a dye-sensitized solar cell having a semiconductor electrode of a nanoparticle oxide.

### 2. Description of the Related Art

A dye-sensitized solar cell is a photoelectrochemical solar cell including photosensitive dye molecules capable of absorbing visible rays to generate an electron-hole pair and a transition metal oxide, which transfers the resulting electrons, unlike a silicon solar cell. Representative examples of the dye-sensitized solar cell known include those reported by Gratzel, et al., in U.S. Patent Nos. 4,927,721 and 5,350,644. The solar cells by Gratzel, et al. include a semiconductor electrode composed of nanoparticle titanium dioxide (TiO₂), which is covered with dye molecules, a Pt electrode, and an electrolyte solution interposed therebetween. Such a cell has come into the spotlight in terms of the probability of replacing a conventional silicon solar cell due to lower production costs per power compared to the conventional silicon solar cell.

A general semiconductor electrode of a nanoparticle oxide is completed by coating a colloidal solution of a nanoparticle oxide on a conducting glass substrate and heating the substrate in an electric furnace at 450-500°C. The heating is performed in order to increase an electric contact between nanoparticle oxides and remove a polymer added when preparing the colloidal solution to improve photoelectrical properties. The heating temperature of 450-500°C is relatively high, but the glass substrate can be used even at such a high temperature without distortion. However, it is impossible to bend a prepared solar cell in terms of characteristics of a glass substrate. Thus, application fields, which require bending, have been excluded.

Developments and studies of a flexible dye-sensitized solar cell have been actively conducted since 2000's. Up to now, a nanoparticle oxide layer formed by coating a colloidal solution prepared by dispersing a nanoparticle oxide in a solution, such as ethanol, which is volatile at low temperatures, on a substrate and then pressing the coating by heat treatment at about 100°C and a nanoparticle oxide layer formed by coating a colloidal solution prepared using an organic dispersant on a substrate and removing the dispersant through UV irradiation and heating at about 100°C were developed. However, the above products show very low photo conversion efficiency (i.e., energy conversion efficiency) compared to the conventional dye-sensitized solar cell using a glass substrate in the high temperature process.

A dye-sensitized solar cell having a nanoparticle oxide layer on a metal substrate of Ti or Zn as a conducting metal was reported to have a superior photo conversion efficiency (EP 1095387).

### SUMMARY OF THE INVENTION

The present invention provides a dye-sensitized solar cell which has superior energy conversion efficiency and is flexible.

According to the present invention, there is provided a dye-sensitized solar cell including a semiconductor electrode having a first flexible conducting substrate composed of a metal, a conducting thin film formed on the first conducting substrate, a nanoparticle oxide layer formed on the conducting thin film, and dye molecules adsorbed on the nanoparticle oxide layer.

The conducting thin film may be composed of indium tin oxide (ITO) or F-doped SnO₂ (FTO). The dye-sensitized solar cell may further include an insulating thin film or semiconductor thin film between the first conducting substrate and the conducting thin film. The first conducting substrate may be a SUS or Al substrate.

In the dye-sensitized solar cell, the second conducting substrate may be a polymer substrate of polyethyleneterephthalate, polycarbonate, polyimide, polyethylenenaphthalate or polyethersulfone coated with a conducting material, such as ITO or FTO. The nanoparticle oxide layer may be a layer of TiO₂, SnO₂ or ZnO.

### BRIEF DESCRIPTION OF THE DRAWINGS

The above and other features and advantages of the present invention will become more apparent by describing in detail exemplary embodiments thereof with reference to the attached drawings in which:
FIG. 1 is a schematic cross-sectional view of a flexible dye-sensitized solar cell according to an embodiment of the present invention;
FIG. 2 is a schematic cross-sectional view of a flexible dye-sensitized solar cell according to another embodiment of the present invention; and
FIG. 3 illustrates photocurrent-voltage curves of the dye-sensitized solar cells of FIGS. 1 and 2.

### DETAILED DESCRIPTION OF THE INVENTION

The present invention will now be described more fully with reference to the accompanying drawings, in which exemplary embodiments of the invention are shown. The invention may, however, be embodied in many different forms and should not be construed as being limited to the embodiments set forth herein; rather, these embodiments are provided so that this disclosure will be thorough and complete, and will fully convey the concept of the invention to those skilled in the art.

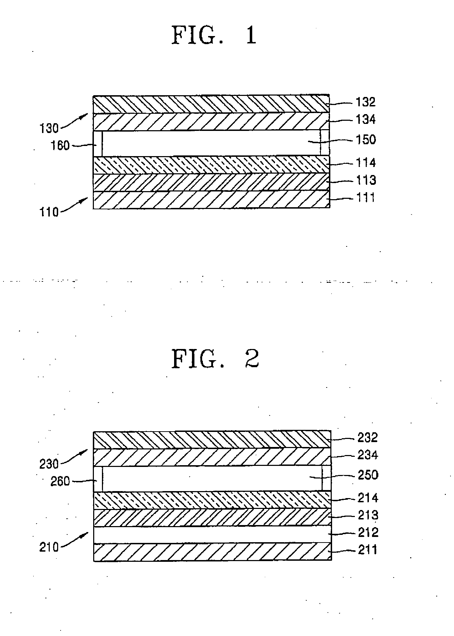

FIG. 1 is a schematic cross-sectional view of a flexible dye-sensitized solar cell according to an embodiment of the present invention.

Referring to FIG. 1, the flexible solar cell according to an embodiment of the present invention includes a semiconductor electrode 110, a counter electrode 130, and an electrolyte solution 150 interposed therebetween. The electrolyte solution 150 can be sealed with a thermoplastic polymer material 160, such as surlyn (Dupont product 1702) to prevent leaking thereof.

The semiconductor electrode 110 includes a conducting thin film 113 formed on a first flexible conducting substrate 111, which is composed of a metal. For example, the semiconductor electrode 110 can be formed by coating ITO as a conducting material on a stainless steel to a thickness of about 1000-2000 Å. However, all metals can be used in the first conducting substrate 111 because the electrolyte solution 150 can be considerably prevented from contacting a surface of the first conducting substrate 111 by the conducting thin film 113. In view of costs and resource deposits, a stainless steel comprising Fe as a main constituent or a Al substrate are preferably used.

The semiconductor electrode 110 includes a nanoparticle oxide layer 114 with a thickness of 5-15 µm formed on the conducting thin film 113. Dye molecules composed of, for example, a Ru complex, are chemically adsorbed on the nanoparticle oxide layer 114. The nanoparticle oxide layer 114 is composed of TiO₂, SnO₂ or ZnO.

In the solar cell of the present embodiment, a colloidal solution of the nanoparticle oxide coated on the first conducting substrate 111 composed of a metal can be heated. Thus, an energy conversion efficiency of the solar cell of the present embodiment can be significantly improved when compared to other conventional flexible solar cells having a first conducting substrate composed of a polymer material, such as PET.

The counter electrode 130 includes a Pt layer 134 formed on a second flexible conducting substrate 132 composed of a transparent polymer material. The Pt layer 134 is positioned so as to face the nanoparticle oxide layer 114. The second conducting substrate 132 is a transparent polymer substrate, such as polyethyleneterephthalate (PET, also called polyterephthalic acid ethylene), polycarbonate (also called polyester carbonate), polyimide, polyethylenenaphthalate or polyethersulfone (PES) coated with a transparent conducting material, such as ITO or F-doped SnO₂ (FTO). PET is a proper material to practice the present invention in view of better heat resistance, elasticity recovery and water resistance. Polycarbonate has better dimensional stability, light transmittance and impact resistance. Polyethylenenaphthalate can be used in the practice of the present invention in view of better water resistance and moisture proof property.

When the same conducting thin film 113 as the conducting material of the second conducting substrate 132 is formed on the first conducting substrate 111, a voltage difference due to different materials of the first conducting substrate 111 and the second conducting substrate 132 cannot be induced, thereby improving the energy conversion efficiency.

The Pt layer 134 can be formed, for example, by dispersing a 5 mM hexachloroplatinic acid (H₂PtCl₆ · ₓH₂O) aqueous solution on a kind of polymer substrate as listed above and drying the solution to cover the substrate with Pt ions, then treating the resulting substrate with a 60 mM sodium borohydrate (NaBH₄) aqueous solution to reduce Pt ions to Pt, and finally washing the substrate with distilled water and drying.

The electrolyte solution 150 can be an iodine based oxidation-reduction liquid electrolyte, for example, a l₃⁻ /l⁻ electrolyte solution obtained by dissolving 0.8 M 1,2-dimethyl-3-octyl-imidazolium iodide and 40 mM iodine (l₂) in 3-methoxypropionitrile.

The solar cell according to the present embodiment is operated as follows.

Light transmitted to the second transparent conducting substrate 132 of the counter electrode 130 is passed through the Pt layer 134, and then absorbed by dye molecules, which are adsorbed on the nanoparticle oxide layer 114. Then, an electron transition of dye molecules from the ground state to the excited state occurs to form electron-hole pairs and the excited electrons are injected to a conduction band of the nanoparticle oxide layer 114. The electrons injected to the nanoparticle oxide layer 114 are transferred to the first conducting substrate 111, which contacts the nanoparticle oxide layer 114, through an interface between particles. Then, the electrons migrate to the counter electrode 30 through an external electric wire (not shown). The dye molecules oxidized due to the electron transition accept electrons provided by an oxidation of iodine ions (3l⁻ → l₃⁻ + 2e⁻) in the electrolyte solution 150. The oxidized iodine ions (l₃⁻ ) are reduced by electrons arrived at the counter electrode 130, thereby completing the operation of the dye-sensitized solar cell.

FIG. 2 is a schematic cross-sectional view of a flexible dye-sensitized solar cell according to another embodiment of the present invention.

Referring to FIG. 2, the flexible solar cell according to another embodiment of the present invention includes a semiconductor electrode 210, a counter electrode 230, and an electrolyte solution 250 interposed therebetween. The electrolyte solution 250 can be sealed with a thermoplastic polymer material 260 to prevent leaking thereof.

The semiconductor electrode 210 is obtained by forming an insulating thin film or semiconductor thin film 212 on a first flexible conducting substrate 211, which is composed of a metal and subsequently forming a conducting thin film (ITO or FTO) 213 thereon. For example, the semiconductor electrode 110 can be obtained by coating silicon oxide (SiOx) as an insulating layer 212 on a stainless steel to a thickness of about 1000-2000 Å, and subsequently coating ITO as a conducting thin film 213 thereon to a thickness of 1000-2000 Å. The counter electrode 230 and the electrolyte solution 250 are the same as in the above embodiment.

Although the conducting thin film 113 is formed on the first conducting substrate 111 as in just above embodiment, it is difficult to completely separate the electrolyte solution 150 from the metal of the first conducting substrate 111 by the conducting thin film 113 formed on the first conducting substrate 111. For extended period, the electrolyte solution 150 permeates the conducting thin film 113 formed on the first conducting substrate 111 to reach to the metal of the first conducting substrate 111, thereby inducing a voltage difference.

Thus, when the insulating thin film or semiconductor thin film 212, which can completely separate the electrolyte, is formed on the metal of the first conducting substrate 211, and then the conducting thin film 213 is formed thereon, a voltage difference due to different materials of the first conducting substrate 211 and the second conducting substrate 232 is not induced, long-period stability is improved, and energy conversion efficiency is significantly increased.

### Example

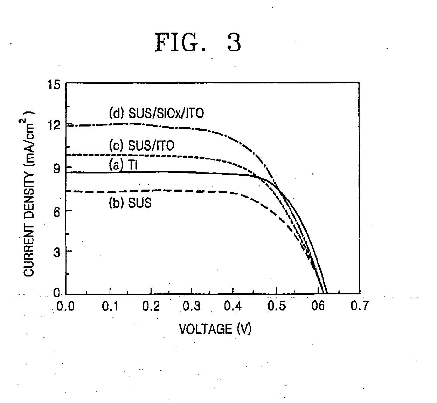

Solar cells were prepared according to the methods described above, and then, comparison of characteristics with prior art (EP1095387 etc.) was conducted. FIG. 3 shows photocurrent-voltage characteristics of the flexible solar cells prepared according to the embodiments of the present invention and prior art.

A 3-methoxypropionitrile solution containing 0.7 M 1-vinyl-3-methylimidazolium iodide, 0.1 M lithium iodide (LiI), 0.04 M l₂, and 0.13 M 4-tert-butylpyridine was used as an electron solution. In FIG. 3, a solid line (a) is for the solar cell using a Ti substrate (such as EP1095387) as the first conducting substrate according to prior art, a dashed line (b) is for the solar cell using a stainless steel as the first conducting substrate according to another prior art, a dotted line (c) is for the solar cell using a stainless steel as the first conducting substrate 111 and ITO as the conducting thin film 113 according to an embodiment of the present invention, and a dotted and dashed line (d) is for the solar cell using a stainless steel as the first conducting substrate 211, SiOx as the insulating thin film 212 and ITO as the conducting thin film 213 according to another embodiment of the present invention.

The photoelectrical characteristics calculated from FIG. 3 are given in Table 1.

**Table 1**

| Structure of semiconductor electrode | Photocurrent density mA/cm² | Photovoltage V | Efficiency % |
|---|---|---|---|
| Ti | 8.14 | 0.62 | 3.60 |
| Stainless steel | 7.57 | 0.61 | 3.09 |
| Stainless steel/conducting thin film (ITO) | 10.2 | 0.61 | 3.94 |
| Stainless steel/insulating thin film (SiOx) /conducting thin film (ITO) | 12.3 | 0.61 | 4.58 |

As apparent from FIG. 3 and Table 1, when using the stainless steel as the first conducting substrate, the solar cell is flexible and has an energy conversion efficiency of about 3% which is lower than that of the Ti substrate. However, according to the present invention, energy conversion efficiencies of 3.94% and 4.58% are obtained even with the stainless steel substrate. It can be confirmed that the conducting thin film and insulating thin film are applied to the stainless steel to prevent the electrolyte solution from contacting the metal of the first conducting substrate as described above, thereby improving the energy conversion efficiency.

As describe above, the present invention relates to a dye sensitized solar cell using a flexible metal substrate, a metal substrate with a conducting material coated thereon, or a metal substrate with a insulating (or semiconductor) thin film/conducting thin film formed thereon as a first conducting substrate. In the dye sensitized solar cell, a nanoparticle oxide layer can be formed by a high temperature process, which was not possible in a conventional flexible polymer substrate. The nanoparticle oxide layer formed at high temperatures is very stable, and thus is not deformed or released by bending action. Thus, the solar cells according to the embodiments of the present invention have an improved energy conversion efficiency when compared to the conventional method and can be bended. The flexible solar cell including a flexible metal substrate and a thin film formed thereon has a thickness of 1 mm or less, and thus is light and can be variously applied.

When a flexible dye-sensitized solar cell is prepared by forming a nanoparticle oxide layer on the first conducting substrate as proposed in the present invention, and then applying a Pt ion solution on a second conducting polymer substrate and reducing Pt ions to form a Pt layer, the photo conversion efficiency can be significantly improved when compared to a flexible solar cell conventionally known. Since this flexible solar cell can be variously applied without significantly reducing the energy conversion efficiency compared to a conventional inflexible solar cell using a glass substrate, its commercial value are expected to be high. Further, since the polymer substrate, etc. is lighter.than a glass substrate, a light weighted solar cell can be obtained.

In addition, a metal, which has better cost competitiveness and availability compared to Zn or Ti metal, is used as a conducting metal in the present invention.

While the present invention has been particularly shown and described with reference to exemplary embodiments thereof, it will be understood by those of ordinary skill in the art that various changes in form and details may be made therein without departing from the spirit and scope of the present invention as defined by the following claims. For example, a solar cell using a conducting glass substrate instead of the polymer substrate as the second conducting substrate is not flexible, but can be constructed.

## Claims

1. A dye-sensitized solar cell comprising:
a semiconductor electrode including a first flexible conducting substrate composed of a metal, a conducting thin film formed on the first conducting substrate, an nanoparticle oxide layer formed on the conducting thin film, and dye molecules adsorbed on the nanoparticle oxide layer;
a counter electrode including a second flexible conducting substrate composed of a flexible transparent polymer and a Pt layer formed on the second conducting substrate; and
an electrolyte solution interposed between the semiconductor electrode and the counter electrode.

2. The dye-sensitized solar cell of claim 1, wherein the conducting thin film is composed of indium tin oxide (ITO) or F-doped SnO₂ (FTO).

3. The dye-sensitized solar cell of claim 1, further comprising an insulating thin film or semiconductor thin film between the first conducting substrate and the conducting thin film.

4. The dye-sensitized solar cell of claim 1, wherein the first conducting substrate is a stainless steel substrate or Al substrate.

5. The dye-sensitized solar cell of claim 1, wherein the second conducting substrate is a polymer substrate of polyethyleneterephthalate, polycarbonate, polyimide, polyethylenenaphthalate or polyethersulfone coated with a conducting material.

6. The dye-sensitized solar cell of claim 5, wherein the conducting material is ITO or FTO.

7. The dye-sensitized solar cell of claim 1, wherein the nanoparticle oxide layer is a layer of TiO₂, SnO₂ or ZnO.

8. The dye-sensitized solar cell of claim 3, wherein the first conducting substrate is a stainless steel substrate or Al substrate.

9. The dye-sensitized solar cell of claim 3, wherein the second conducting substrate is a polymer substrate of polyethyleneterephthalate, polycarbonate, polyimide, polyethylenenaphthalate or polyethersulfone coated with a conducting material.

10. The dye-sensitized solar cell of claim 9, wherein the conducting material is indium tin oxide (ITO) or F-doped SnO₂ (FTO).

11. The dye-sensitized solar cell of claim 3, wherein the nanoparticle oxide layer is a layer of TiO₂, SnO₂ or ZnO.
